(19) Europäisches Patentamt
European Patent Office
Office européen des brevets

(11) **EP 1 785 016 B1**

(12) **EUROPÄISCHE PATENTSCHRIFT**

(45) Veröffentlichungstag und Bekanntmachung des Hinweises auf die Patenterteilung:
**27.05.2009 Patentblatt 2009/22**

(21) Anmeldenummer: **05776119.9**

(22) Anmeldetag: **24.08.2005**

(51) Int Cl.:
**H05K 3/12** (2006.01)

(86) Internationale Anmeldenummer:
**PCT/EP2005/009137**

(87) Internationale Veröffentlichungsnummer:
**WO 2006/024441 (09.03.2006 Gazette 2006/10)**

(54) **MEHRSCHICHTIGER KÖRPER MIT UNTERSCHIEDLICH MIKROSTRUKTURIERTEN BEREICHEN MIT ELEKTRISCH LEITFÄHIGER BESCHICHTUNG**

MULTILAYER BODY WITH DIFFERENTLY MICROSTRUCTURED AREAS PROVIDED WITH AN ELECTROCONDUCTIVE COATING

CORPS MULTICOUCHE AYANT DES ZONES DE DIFFERENTES MICROSTRUCTURATIONS DOTEES D'UN REVETEMENT ELECTROCONDUCTEUR

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **30.08.2004 DE 102004042111**

(43) Veröffentlichungstag der Anmeldung:
**16.05.2007 Patentblatt 2007/20**

(73) Patentinhaber: **OVD Kinegram AG**
**6301 Zug (CH)**

(72) Erfinder:
• **SCHILLING, Andreas**
**CH-6332 Hagendorn (CH)**
• **TOMPKIN, Wayne, Robert**
**CH-5400 Baden (CH)**

(74) Vertreter: **Zinsinger, Norbert et al**
**Louis Pöhlau Lohrentz,**
**P.O. Box 30 55**
**90014 Nürnberg (DE)**

(56) Entgegenhaltungen:
**US-A1- 2002 041 009       US-A1- 2004 213 954**
**US-B1- 6 284 072**

• **PATENT ABSTRACTS OF JAPAN Bd. 2000, Nr. 26, 1. Juli 2002 (2002-07-01) & JP 2001 256457 A (TOSHIBA CORP), 21. September 2001 (2001-09-21)**

**Beschreibung**

Die Erfindung betrifft einen mehrschichtigen Körper mit einer Replizierlackschicht, in der eine Reliefstruktur abgeformt ist und die mit einer elektrisch leitfähigen Beschichtung versehen ist.

Die US 6,284,072 B1 beschreibt einen derartigen mehrschichtigen Körper mit einer Replizierlackschicht, in welcher eine Reliefstruktur ausgebildet wird, wobei eine elektrisch leitfähige Beschichtung in Kanäle der Reliefstruktur eingebracht wird.

Mehrschichtige Körper in Form von Folienelementen werden in vielen Bereichen eingesetzt, beispielsweise als Sicherheitselemente zur Erzeugung optischer Effekte. Sie werden auch als Teil einer elektrischen Schaltung eingesetzt oder sie bilden selbst eine elektrische Schaltung, beispielsweise einen Schaltkreis. Solche Schaltkreise finden beispielsweise Anwendung als sog. RFID-Tags (RFID = Radio Frequency-Identification), d.h. Warenetiketten zur Identifikation von Waren mittels Radiofrequenzen. Unter RF-Identifikation ist allgemein eine kontaktlose RF-Kommunikation zwischen einem Transponder, der einem Gegenstand oder einer Person zugeordnet ist, und einer Lesevorrichtung zu verstehen. Der Transponder weist hierbei beispielsweise eine Antenne auf, die Teil eines Resonanzschaltkreises ist und/oder mit einem Halbleiterchip verbunden ist.

Für solche Einsatzzwecke müssen leitfähige Strukturen auf bzw. in dem Folienelement erzeugt werden, die sehr geringe Abmessungen haben. Dazu sind verschiedene Prozeßschritte durchzuführen, die arbeitsaufwendig, umweltbelastend oder qualitätsmindernd sind, wie beispielsweise das Ätzen elektrisch leitfähiger Schichten. Durch das Ätzen kann beispielsweise eine unter den leitfähigen Strukturen angeordnete Halbleiterschicht verunreinigt werden, wobei bereits kleinste Mengen von Fremdatomen eine bedeutende Störquelle sein können.

Wegen des Schichtaufbaus von Schaltkreisen sind im allgemeinen mehrere Zyklen solcher Prozeßschritte erforderlich, so daß weiterer Aufwand zur passergenauen Fertigung zu verzeichnen ist.

Der Erfindung liegt nun die Aufgabe zugrunde, die genannten Nachteile zu vermeiden und mehrschichtige Körper mit strukturierten elektrisch leitenden Beschichtungen anzugeben, die mit geringen Kosten, mit hoher Präzision und mit hoher Auflösung herstellbar sind.

Die Aufgabe der Erfindung wird von einem mehrschichtigen Körper mit einer Replizierlackschicht gelöst, wobei in einer von Koordinatenachsen x und y aufgespannten Ebene in die Replizierlackschicht eine erste Reliefstruktur in einem ersten Bereich des mehrschichtigen Körpers abgeformt ist und auf die Replizierlackschicht in dem ersten Bereich des mehrschichtigen Körpers und in einem benachbarten zweiten Bereich des mehrschichtigen Körpers eine elektrisch leitfähige Beschichtung mit konstanter Flächendichte aufgebracht ist. Die erste Reliefstruktur ist eine Struktur mit einem hohen Tiefen-zu-Breiten-Verhältnis der einzelnen Strukturelemente von > 2, und ist mit mindestens einer sich über die gesamte oder einen wesentlichen Teil der Tiefe der Reliefstruktur erstreckenden senkrechten oder nahezu senkrechten Flanke ausgebildet, wobei sich an den senkrechten oder nahezu senkrechten Flanken der ersten Reliefstruktur Bereiche ergeben, an denen die auf die erste Reliefstruktur aufgebrachte leitfähige Beschichtung nicht angelagert ist oder nur in einer derart geringen Schichtdicke angelagert ist, daß die elektrische Leitfähigkeit der Beschichtung im Bereich der Flanken signifikant verringert ist. Die Aufgabe der Erfindung wird weiter mit einem Verfahren zur Herstellung eines mehrschichtigen Körpers gelöst, wobei bei dem Verfahren in eine Replizierlackschicht des mehrschichtigen Körpers in einem ersten Bereich des mehrschichtigen Körpers eine erste Reliefstruktur abgeformt wird und auf die Replizierlackschicht in dem ersten Bereich des mehrschichtigen Körpers und in einem benachbarten zweiten Bereich des mehrschichtigen Körpers eine elektrisch leitfähige Beschichtung mit konstanter Flächendichte aufgebracht wird. Die erste Reliefstruktur wird als eine Struktur mit einem hohen Tiefen-zu-Breiten-Verhältnis der einzelnen Strukturelemente von > 2, und mindestens einer senkrechten oder nahezu senkrechten Flanke abgeformt, wobei sich an den senkrechten oder nahezu senkrechten Flanken der ersten Reliefstruktur Bereiche ergeben, an denen die auf die erste Reliefstruktur aufgebrachte leitfähige Beschichtung nicht angelagert ist oder nur in einer derart geringen Schichtdicke angelagert ist, daß die elektrische Leitfähigkeit der Beschichtung im Bereich der Flanken signifikant verringert ist.

Dadurch, daß die erste Reliefstruktur mit einem derart hohen Tiefen-zu-Breiten-Verhältnis von >2 und mit mindestens einer senkrechten oder nahezu senkrechten Flanke ausgebildet ist, ergeben sich an den Flanken der Reliefstruktur Bereiche, an denen die auf der Reliefstruktur aufgebrachte leitfähige Beschichtung sich nicht anlagert oder sich nur in einer derart geringen Schichtdicke anlagert, daß die elektrische Leitfähigkeit der Beschichtung im Bereich der Flanken signifikant verringert ist oder die Beschichtung dort gar ganz unterbrochen ist. Von besonderem Vorteil ist hierbei die hohe erreichbare Auflösung, d.h. es ist die Ausbildung sehr feiner Leitungsstrukturen möglich, wie sie durch ein optisches Belichtungsverfahren mit anschließender Ätzung nicht durchführbar ist. Weiter ist es möglich, mittels der Erfindung den Flächenwiderstand von Leitungsbereichen präzise einzustellen und auf diese Weise auslesbare Informationen in Sicherheitselemente zu kodieren.

Das dimensionslose Tiefen-zu-Breiten-Verhältnis ist ein kennzeichnendes Merkmal für die Charakterisierung von Strukturen, insbesondere von Mikrostrukturen. Es wird vorzugsweise verwendet, um periodischer Strukturen, beispielsweise mit sägezahnförmigem Verlauf, zu beschreiben. Als Tiefe ist hier der Abstand zwischen dem höchsten und dem tiefsten aufeinanderfolgenden Punkt der Struktur bezeichnet, d.h. es handelt sich um den Abstand zwischen "Berg" und "Tal". Als Breite ist der Abstand zwischen zwei benachbarten höchsten Punkten, d.h. zwischen zwei "Bergen", bezeichnet (Periode). Je höher nun das Tiefen-zu-Breiten-Verhältnis ist, desto steiler sind die "Bergflanken" ausgebildet. Auch auf nichtperiodische Strukturen kann das Beschreibungsmodell angewendet werden. Beispielsweise kann es sich um diskret verteilte linienförmige Bereiche handeln, die nur als ein "Tal" ausgebildet sind, wobei der Abstand zwischen zwei "Tälern" um ein Vielfaches höher ist als die Tiefe der "Täler". Bei formaler Anwendung der vorstehend genannten Definition würde das so berechnete Tiefen-zu-Breiten-Verhältnis annähernd Null sein und nicht das charakteristische physikalische Verhalten widerspiegeln. Deshalb ist bei diskret angeordneten Strukturen, die im wesentlichen nur aus einem "Tal" gebildet sind, die Tiefe des "Tales" zur Breite des "Tales" ins Verhältnis zu setzen.

Trotz der o.g. Vorzüge ist das erfindungsgemäße Herstellungsverfahren kostengünstig, denn es vermeidet aufwendige Prozeßschritte zur Strukturierung von Leiterbahnen.

Es ist vorgesehen, daß die erste Reliefstruktur als eine Funktion der Koordinaten x und/oder y ausgebildet ist, die die Tiefe der ersten Reliefstruktur periodisch in x-Richtung und/oder in y-Richtung variiert. Dabei sind Funktionen bevorzugt, die mindestens eine senkrechte Flanke ausbilden. Bevorzugt sind Sägezahnfunktionen und Rechteckfunktionen. Auf diese Weise sind senkrechte Flanken mit scharfen Kanten ausgebildet, so daß längs der Kanten die leitfähige Beschichtung mit definierter Kontur unterbrochen ist. Auf diese Weise ist die Beschichtung auf der ersten Reliefstruktur in Richtung senkrecht der Kanten elektrisch nichtleitend oder mit einem sehr hohen elektrischen Widerstand ausgebildet.

Die Dicke t der Beschichtung, die auf einer mit einem Winkel $\alpha$ zur Waagerechten geneigten schrägen Flanke abgeschieden wird, ist durch die Beziehung

$$t = t_0 \cdot \cos \alpha$$

gegeben. Dabei ist $t_0$ die Dicke der auf einer waagerechten Fläche abgeschiedenen Beschichtung. Die Dicke $t_0$ ist dabei in Abhängigkeit von dem Beschichtungsmaterial so einzustellen, daß die geneigten Flanken nicht "verschmiert" werden, d.h. dort kein Beschichtungsmaterial oder lediglich eine deutlich gegen planare Flächen verringerte Schichtdicke abgelagert wird. Mit steigender Dicke $t_0$ kann sich unter Umständen auch an einer senkrechten oder nahezu senkrechten Flanke anlagern, beispielsweise wenn Partikel des Beschichtungsmaterials sich nicht auf der gemeinsamen Flugbahn des Partikelstroms bewegen. Der optimale Wert kann vorzugsweise durch eine Versuchsreihe ermittelt werden. Der optimale Wert der Dicke $t_0$ ist daran orientiert, daß sich an der Flanke der ersten Reliefstruktur Bereiche ergeben, an denen die auf die erste Reliefstruktur aufgebrachte leitfähige Beschichtung nicht angelagert ist oder nur in einer derart geringen Schichtdicke angelagert ist, daß die elektrische Leitfähigkeit der Beschichtung im Bereich der Flanke signifikant verringert ist.

Die Dicke $t_0$ unstrukturierter Bereiche sollte kleiner 500 nm sein, vorzugsweise kleiner 50 nm. Die optimale Dicke $t_0$ kann vorteilhafterweise durch Versuch bestimmt werden, wodurch auch der Einfluß des Beschichtungsmaterials auf die elektrischen und andere Eigenschaften des Beschichtungsmaterials berücksichtigt werden kann.

Wenn die zu beschichtende Reliefstruktur ein hohes Tiefen-zu-Breiten-Verhältnis von >2 aufweist, wird der Effekt der Ausbildung von Bereichen an den senkrechten oder nahezu senkrechten Flanken der ersten Reliefstruktur, an denen die auf die erste Reliefstruktur aufgebrachte leitfähige Beschichtung nicht angelagert ist oder nur in einer derart geringen Schichtdicke angelagert ist, daß die elektrische Leitfähigkeit der Beschichtung im Bereich der Flanken signifikant verringert ist, vorteilhaft unterstützt.

Wie Versuche ergeben haben, kann der Winkel $\alpha$ der Flanken betragsmäßig um etwa 10° von der Senkrechten abweichen, ohne den beschriebenen Effekt in Frage zu stellen.

Die Dicke t der Beschichtung auf den Flanken ist durch Wahl des Winkels $\alpha$ einstellbar. Dabei kann es sich bei dem Winkel $\alpha$ auch um den Neigungswinkel eines Kurvenabschnitts handeln, der durch die erste Ableitung der Kurve bestimmbar ist.

Wenn die erste Reliefstruktur als eine Funktion einer Koordinate ausgebildet ist, ist die Reliefstruktur besonders einfach ausgebildet. Insbesondere kann es sich bei der ersten Reliefstruktur um eine diffraktive Struktur handeln mit kleinen Gitterperioden, beispielsweise in einem Bereich von 50 nm bis 10 $\mu$m ausgebildet. Bei einer solchen Reliefstruktur kann es sich um ein lineares Beugungsgitter handeln.

Es kann vorgesehen sein, auf diese Weise einen Linearpolarisator auszubilden, vorzugsweise mit einer Periodenlänge von 100 nm bis 800 nm ausgebildet. Vorzugsweise kann eine Dicke $t_0$ < 10 nm der Beschichtung vorgesehen sein. Wegen der hohen möglichen Auflösung der ersten Reliefstruktur ist die Ausbildung des Linearpolarisators nicht auf die Ausbildung für die Polarisation in einer Schwingungsebene beschränkt. Vielmehr kann es vorgesehen sein, auf diese Weise nebeneinander liegende Bereiche mit unterschiedlicher Polarisationsrichtung auszubilden, wobei die Bereiche als Informationsträger ausgebildet sein können. Beispielsweise können die Bereiche einen maschinenlesbaren Strichcode bilden oder als alphanumerische Zeichen oder als bildliche Darstellung ausgebildet sein. Diese Bereiche können in polarisiertem Licht sichtbar sein, z.B. wenn sie so ausgerichtet sind, daß ihre Polarisationsebene senkrecht zur Polarisationsebene des auf- oder hindurchgestrahlten Lichts orientiert ist, wodurch sie sich dunkel vom Hintergrund abheben. Es kann auch eine "Entschlüsselungs"-Folie vorgesehen sein, die bei Beleuchtung mit unpolarisiertem Licht in Verbindung mit der vorstehend beschriebenen Struktur verborgene Informationen hervortreten läßt.

Es kann aber auch vorgesehen sein, die erste Reliefstruktur als eine Funktion zweier Koordinaten auszubilden, wobei die vorgesehenen senkrechten Flanken als in sich geschlossene Kurven ausgebildet sind. Auf diese Weise ist die elektrische Leitfähigkeit der aufgebrachten Beschichtung in alle Richtungen unterbrochen. Vorzugsweise kann vorgesehen sein, die geschlossenen Kurven als Kreise, Ellipsen, Quadrate, Rechtecke und Rhomben auszubilden.

Es kann aber auch vorgesehen sein, daß die geschlossene Kurve der Kontur eines benachbarten zweiten Bereiches folgt, in dem eine zweite Reliefstruktur abgeformt ist. Vorzugsweise ist vorgesehen, die zweite Reliefstruktur planar auszubilden. Auf diese Weise ist die auf der zweiten Reliefstruktur aufgebrachte elektrisch leitfähige Beschichtung als elektrischer Leiter mit voller Dicke $t_0$ ausgebildet. Weil ein beliebig konturierter elektrisch leitfähiger zweiter Bereich von dem ersten elektrisch nicht leitenden Bereich umgeben sein kann, sind auf diese Weise voneinander elektrisch isolierte Leiterzüge beliebiger Geometrie mit hoher Genauigkeit und Auflösung durch einen gemeinsamen Beschichtungsschritt ausbildbar.

Weitere vorteilhafte Ausbildungen der Erfindung sind in den Unteransprüchen bezeichnet.

Vorzugsweise ist vorgesehen, daß die elektrisch leitfähige Beschichtung als eine Metallschicht ausgebildet ist, bevorzugt aus einem guten elektrischen Leiter ausgebildet, wie Aluminium, Kupfer, Silber oder Gold. Es kann aber auch vorgesehen sein, daß die Beschichtung als transparentes leitfähiges Material ausgebildet ist, zum Beispiel als eine Indium-Zinnoxid-Schicht (ITO), die wegen ihrer Transparenz für die Ausbildung "unsichtbarer" Leiterbahnen bevorzugt ist, wie sie beispielsweise in Displays Anwendung finden. Nach dem gleichen Prinzip können Elektrodenschichten für die Fotovoltaik ausgebildet sein.

Es kann aber auch vorgesehen sein, eine metallische Beschichtung so dünn auszubilden, daß sie transparent erscheint, beispielsweise mit einer Dicke von 1 nm bis 100 nm ausgebildet, vorzugsweise mit einer Dicke von 5 nm bis 30 nm ausgebildet. Dies kann von Vorteil sein, wenn auf diese Weise "unsichtbare" Leiterbahnen für geringe Ströme ausgebildet sind, wie sie beispielsweise für LCD-Displays vorgesehen sind.

Insbesondere bei der Ausbildung von Leiterbahnen kommt es darauf an, daß die Beschichtung an den Kanten der Leiterbahnen mit Sicherheit unterbrochen ist. Dazu kann die bevorzugte Schichtdicke $t_0$ im Bereich 5 nm bis 50 nm sein. Wie weiter unten beschrieben, kann die Leitfähigkeit dieser dünnen Leiterbahnen erforderlichenfalls durch Galvanisieren erhöht werden.

Vorzugsweise ist der mehrschichtige Körper als Folienelement ausgebildet, beispielsweise als Transferfolie, insbesondere Heißprägefolie, als laminierte oder Stickerfolie ausgebildet. Das Folienelement kann hierbei auch von der applizierten Übertragungslage einer Transferfolie gebildet werden. Es kann aber auch vorgesehen sein, daß der mehrschichtige Körper eine starre Substratschicht, beispielsweise eine dünne Glasschicht umfaßt.

Die elektrisch leitfähige Beschichtung kann mit den aus der Herstellung von Sicherheitselementen bekannten Verfahren aufgebracht werden, beispielsweise durch Sputtern, Elektronenstrahlbedampfen oder thermisches Bedampfen mit Widerstandsheizung. Diese Verfahren zeichnen sich dadurch aus, daß die Beschichtung durch Aufsprühen mit konstanter Flächendichte bezogen auf eine von Koordinatenachsen x und y aufgespannte Ebene aufgebracht wird. Bevorzugt treffen die Atome bzw. Moleküle unter etwa dem gleichen Winkel auf die Ebene, d.h. die zu beschichtende Oberfläche auf.

Vorteilhafterweise kann vorgesehen sein, daß die Atome bzw. Moleküle senkrecht auf die zu beschichtende Oberfläche auftreffen, so daß sie an senkrechte oder nahezu senkrechte Flanken nicht angelagert sind.

Es handelt sich also nicht um ein Beschichtungsverfahren, bei dem die Atome bzw. Moleküle ungerichtet abgeschieden werden, wodurch sie sich unabhängig von der Flankenneigung in einer Schicht mit annähernd gleicher Schichtdicke anlagern. Bei der ungerichteten Abscheidung kann es sich beispielsweise um eine Abscheidung aus der Gasphase handeln.

Vorzugsweise ist vorgesehen, daß die Reliefstrukturen mittels UV-Replikation in der Replizierlackschicht abgeformt werden.

Die Anwendung der erfindungsgemäßen Strukturen und des erfindungsgemäßen Verfahrens ist auf vielfältige Weise möglich und immer dann besonders vorteilhaft, wenn ein diffraktives Folienelement eine elektrische Schaltung tragen soll oder selbst ein Teil eines elektrischen Schaltkreises ist.

Weiter ist es möglich, Elektrodenschichten von Halbleiterbauelementen in Polymer-Elektronik mittels der Erfindung zu strukturieren. Durch die Erfindung ist es möglich hohe Auflösungen zu erzielen. Weiter wird vorgeschlagen, Leiterbahnen polymerer Schaltkreise oder andere elektrische Bauelemente, beispielsweise Spulen und Kapazitäten für RFID-Tags (RFID = Radio Frequency-Identification) in der beschriebenen Weise auszubilden. Besonders vorteilhaft ist hierbei, daß durch die Erfindung eine kostengünstige Herstellungstechnologie mit geringer Ausschußrate für die Herstellung derartiger Strukturen bereitsteht. Wegen der mit dem erfindungsgemäßen Verfahren erreichbaren feinen Strukturierung kann auf diese Weise weiter die Grenzfrequenz dieser Halbleiterbauelemente deutlich erhöht sein.

Es kann vorgesehen sein, die leitfähige Beschichtung galvanisch zu verstärken und auf diese Weise entweder eine besonders gut leitfähige Oberflächenschicht aufzubringen oder die Dicke der abgeschiedenen Schicht zwecks Verminderung des elektrischen Widerstands zu erhöhen. Die o.g. Abscheidungsverfahren sind vorzugsweise für das Aufbringen dünner Schichten geeignet. Wie sich gezeigt hat, wird beim Galvanisieren die Reliefstruktur nicht verändert, d.h. elektrisch nicht leitfähige Bereiche werden nicht überdeckt.

Mit dem erfindungsgemäßen Verfahren ist es möglich, weitere Bauelemente, wie Linearpolarisatoren, besonders preisgünstig als Folienprodukte herzustellen.

Im folgenden wird die Erfindung anhand von mehreren Ausführungsbeispielen unter Zuhilfenahme der beiliegenden Zeichnungen beispielhaft verdeutlicht.

Es zeigen

Fig. 1      eine schematische Schnittdarstellung eines ersten Ausführungsbeispiels eines erfindungsgemäßen mehrschichtigen Körpers, ausgebildet als Folienelement;

Fig. 2      eine schematische Darstellung der Beschichtung des Folienelements in Fig. 1 mit einer Metallschicht;

Fig. 3      eine schematische Schnittdarstellung eines zweiten Ausführungsbeispiels eines erfindungsgemäßen mehrschichtigen Körpers, ausgebildet als Folienelement;

Fig. 4.      eine schematische Darstellung der Beschichtung des Folienelements in Fig. 3 mit einer Metallschicht;

Fig. 5      eine schematische Draufsicht eines Ausführungsbeispiels eines mehrschichtigen Körpers, ausgebildet als Folienelement mit eindimensionaler Reliefstruktur;

Fig. 6      eine schematische Draufsicht eines Ausführungsbeispiels eines mehrschichtigen Körpers, ausgebildet als Folienelement mit zweidimensionaler Reliefstruktur;

Fig. 7      eine schematische Draufsicht eines Ausführungsbeispiels eines mehrschichtigen Körpers, ausgebildet als Folienelement mit elektrischer Leiterbahn.

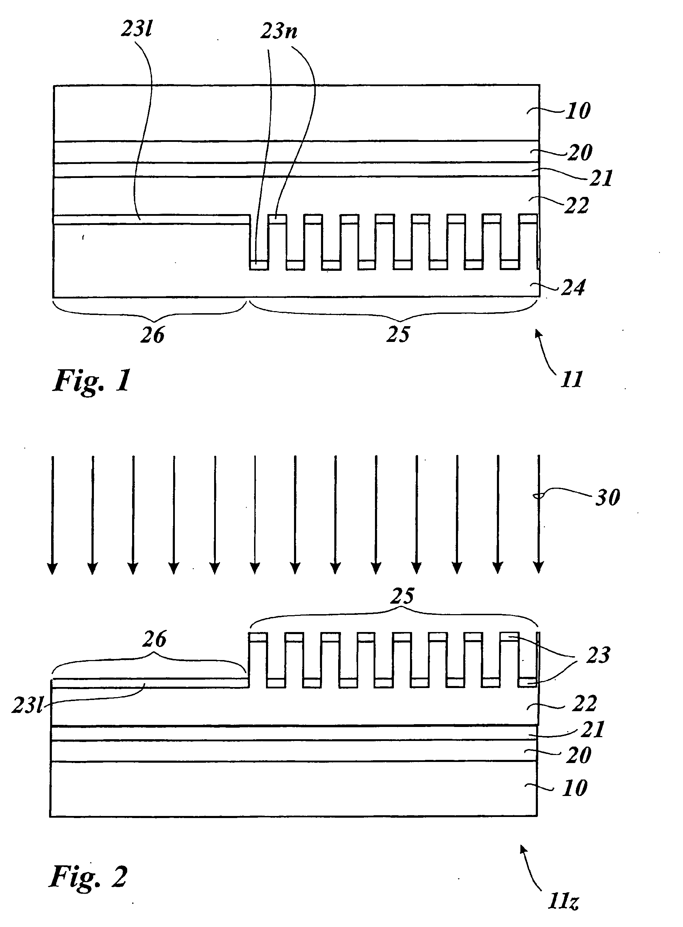

Fig. 1 zeigt einen mehrschichtigen Körper, ausgebildet als ein Folienelement, im folgenden als Folienelement 11 bezeichnet. Das Folienelement 11 weist, eine Trägerfolie 10, eine Ablöseschicht 20, eine Schutzlackschicht 21, eine Replizierlackschicht 22 mit einer ersten Reliefstruktur 25 in einem ersten Bereich und einer zweiten Reliefstruktur 26 in einem zweiten Bereich, auf der ersten Reliefstruktur 25 und der zweiten Reliefstruktur 26 angeordnete Beschichtung 23l, 23n und eine Klebeschicht 24 auf. Die zweite Reliefstruktur 26 ist als planare Reliefstruktur ausgebildet. Bei der ersten Reliefstruktur 25 handelt es sich um eine Struktur mit hohem Breiten-zu-Tiefen-Verhältnis von >2, und damit hat diese erste Reliefstruktur eine um ein Vielfaches höhere effektive Oberfläche als übliche, beispielsweise für die Erzeugung von optischen Effekten in Sicherheitselementen abgeformte Reliefstrukturen. Die erste Reliefstruktur 25 ist mäanderförmig mit zur Oberfläche der planaren zweiten Reliefstruktur 26 senkrechten Flanken ausgebildet. Sie erstreckt sich in dem dargestellten Ausführungsbeispiel in einer Koordinatenrichtung. Auf diese Weise ist die flächig aufgetragene Beschichtung 23n nur auf den zur Oberfläche der planaren zweiten Reliefstruktur 26 parallelen Abschnitten der ersten Reliefstruktur 25 angeordnet, d.h., es handelt sich um eine in einer Koordinatenrichtung unterbrochene Beschichtung 23n. Eine solche Reliefstruktur, die in einer Koordinatenrichtung unterbrochen ausgebildet ist, wird im folgenden als eindimensionale Reliefstruktur bezeichnet. Wie in Fig. 1 dargestellt, ist die Unterbrechung in der Beschichtung 23n durchgängig ausgebildet. Dagegen ist die auf der planaren zweiten Reliefstruktur 26 angeordnete Beschichtung 23l geschlossen ausgebildet.

In dem dargestellten Ausführungsbeispiel können durch Wahl des Materials und durch Ausbildung der Reliefstruktur unterschiedliche Effekte erzeugt werden. Sind beispielsweise die Beschichtungen 23l, 23n als Metallschichten ausgebildet, handelt es sich bei der Beschichtung 23n um eine nichtleitende Metallschicht, weil diese an den senkrechten Flanken der ersten Reliefstruktur 25 durchgängig unterbrochen ist. Dagegen ist die auf der planaren zweiten Reliefstruktur 26 aufgetragene Metallschicht elektrisch leitend ausgebildet, denn sie ist nicht unterbrochen. Die Beschichtung 23n kann beispielsweise durch Sputtern aufgebracht sein, d.h. durch ein Beschichtungsverfahren, bei dem Partikel mit annähernd gleicher Beschichtungsrichtung auf die Reliefstruktur auftreffen.

Deshalb treffen an den parallel zur Beschichtungsrichtung angeordneten senkrechten Flanken keine oder signifikant wenige Partikel auf, so daß dort die Beschichtung 23n unterbrochen ist oder mit einem signifikant höheren Widerstand pro Flächeneinheit ausgebildet ist, der beispielsweise um mindestens den Faktor 10 höher ist, vorzugsweise um den Faktor 1000 höher ist, als der Widerstand pro Flächeneinheit der leitfähigen Beschichtung 23l außerhalb der senkrechten Flanken.

Ein solches Beschichtungsverfahren zeichnet sich weiter dadurch aus, daß es die Beschichtung mit konstanter Flächendichte, bezogen auf eine von Koordinatenachsen x und y aufgespannte Ebene aufbringt, wobei vorteilhafterweise die Beschichtungsrichtung parallel zu den senkrechten oder annähernd senkrecht zu der Ebene orientierten Flanken der Reliefstruktur ausgerichtet sein kann.

Einen wesentlichen Anteil an dem beschriebenen Effekt der flankenwinkelabhängigen Ausbildung der Dicke der Beschichtung hat das hohe Tiefen-zu-Breiten-Verhältnis der ersten Reliefstruktur 25, das >2 ist. Zum einen sind durch das hohe Tiefen-zu-Breiten-Verhältnis von >2 steile Flanken ausgebildet, zum anderen wird dadurch die zufällige Ablagerung von Partikeln, die von der eingestellten Beschichtungsrichtung abweichen, erschwert.

Ein weiterer Einflußfaktor ist die Dicke der Beschichtung, die auf der planaren zweiten Reliefstruktur 26 ausgebildet ist. Wie Versuche gezeigt haben, tritt der oben beschriebene Effekt für Dicken < 500 nm ein.

Vorzugsweise kann die Dicke der leitfähigen Beschichtung, die auf der planaren zweiten Reliefstruktur 26 ausgebildet ist, < 50 nm sein, um senkrechte oder annähernd senkrechte Flanken in der ersten Reliefstruktur 25 zu erhalten, auf denen mindestens bereichsweise keine leitfähige Beschichtung ausgebildet ist.

Es kann vorgesehen sein, eine solche Schicht transparent auszubilden, beispielsweise mit einer Dicke von etwa 10nm. Auf diese Weise können Leiterbahnen ausgebildet sein, die darunter liegende Strukturen visuell nicht verdecken, beispielsweise LCD-Anzeigeelemente.

Bei dem Folienelement 11 handelt es sich um eine Prägefolie, insbesondere um eine Heißprägefolie. Es ist jedoch auch möglich, das Folienelement 11 als Laminierfolie oder Stickerfolie oder als Träger für einen Schaltkreis, insbesondere einen Polymer-Schaltkreis auszubilden.

Die Trägerschicht 10 besteht beispielsweise aus einer PET- oder BOPP-Folie einer Schichtdicke von 10 $\mu$m bis 50 $\mu$m, vorzugsweise mit einer Dicke von 19 $\mu$m bis 23 $\mu$m. Auf die Trägerfolie werden sodann mittels einer Tiefdruckrasterwalze die Ablöseschicht 20 und die Schutzlackschicht 21 aufgebracht. Die Ablöse- und Schutzlackschichten 20 und 21 haben hierbei vorzugsweise eine Dicke von 0,2 bis 1,2 $\mu$m. Auf diese Schichten könnte auch verzichtet werden.

Sodann wird die Replizierlackschicht 22 aufgebracht.

Die Replizierlackschicht 22 besteht vorzugsweise aus einem strahlenvernetzbaren Replizierlack. Bevorzugt wird ein UV-Replizierverfahren zur Abformung der ersten Reliefstruktur 25 und der zweiten Reliefstruktur 26 in der Replizierlackschicht 22 eingesetzt. Als Replizierlack wird hierbei ein UV-härtbarer Lack verwendet. Das Einbringen der ersten Reliefstruktur 25 und der zweiten Reliefstruktur 26 in die UV-vernetzbare Replizierlackschicht 22 erfolgt hierbei beispielsweise durch UV-Bestrahlung bei der Abformung der Reliefstrukturen in die noch weiche oder flüssige Lackschicht oder durch partielle Bestrahlung und Aushärtung der UV-vernetzbaren Lackschicht. Anstelle eines UV-vernetzbaren Lackes kann hierbei auch ein sonstiger strahlenvernetzbarer Lack eingesetzt werden.

Weiter ist es auch möglich, daß die Replizierlackschicht 22 aus einem transparenten, thermoplastischen Kunststoffmaterial besteht. In die Replizierlackschicht 22 wird anschließend mittels eines Prägewerkzeuges eine Reliefstruktur eingeprägt oder werden mehrere Reliefstrukturen eingeprägt, beispielsweise die erste Reliefstruktur 25 und die zweite Reliefstruktur 26.

Die Dicke, die für die Replizierlackschicht 22 zu wählen ist, wird von der für die erste Reliefstruktur 25 gewählten Profiltiefe bestimmt. Es muß sichergestellt sein, daß die Replizierlackschicht 22 über eine ausreichende Dicke verfügt, um ein Abformen der ersten Reliefstruktur 25 und der zweiten Reliefstruktur 26 zu ermöglichen. Vorzugsweise besitzt die Replizierlackschicht 22 hierbei eine Dicke von 0,1 bis 10 $\mu$m.

Beispielsweise wird die Replizierlackschicht 22 mittels einer Linienraster-Tiefdruckwalze vollflächig mit einem Auftragegewicht von 2,2 g/m$^2$ vor Trocknung auf die Schutzlackschicht 21 aufgebracht. Als Replizierlack wird hierbei ein Lack folgender Zusammensetzung gewählt:

| Komponente | Gewichtsanteil |
|---|---|
| Hochmolekulares PMMA-Harz | 2000 |
| Silikonalcyd ölfrei | 300 |
| Nichtionisches Netzmittel | 50 |
| Niedrigviskose Nitrocellulose | 12000 |
| Toluol | 2000 |
| Diaceton-Alkohol | 2500 |

Anschließend wird die Replizierlackschicht 22 in einem Trockenkanal bei einer Temperatur von 100 bis 120 °C getrocknet.

Sodann werden in die Replizierlackschicht 22 die erste Reliefstruktur 25 und die zweite Reliefstruktur 26 beispielsweise mittels einer aus Nickel bestehenden Matrize bei etwa 130 °C eingeprägt. Zum Einprägen der ersten Reliefstruktur 25 und der zweiten Reliefstruktur 26 wird die Matrize vorzugsweise elektrisch aufgeheizt. Vor dem Abheben der Matrize von der Replizierlackschicht 22 nach Prägung kann die Matrize hierbei wieder abgekühlt werden. Nach Einprägen der ersten Reliefstruktur 25 und der zweiten Reliefstruktur 26 erhärtet der Replizierlack der Replizierlackschicht 22 durch Vernetzung oder in sonstiger Weise.

Weiter ist es auch möglich, die erste Reliefstruktur 25 und die zweite Reliefstruktur 26 durch ein Ablationsverfahren in die Replizierlackschicht 22 einzubringen.

Bei der ersten Reliefstruktur 25 und der zweiten Reliefstruktur 26 handelt es sich hierbei um Reliefstrukturen, die in einem gemeinsamen Beschichtungsverfahen, beispielsweise Sputtern, mit den Beschichtungen 23l, 23n beschichtet werden.

Wie in Fig. 2 zu sehen, ist die Beschichtungsrichtung zur Abscheidung der Beschichtungen 23l, 23n senkrecht zur Oberfläche der planaren zweiten Reliefstruktur 26 orientiert. Die Beschichtungsrichtung ist in Fig. 2 mit Pfeilen 30 bezeichnet. Dabei ist die Beschichtungseinrichtung so ausgebildet, daß das Material mit konstanter Flächendichte auf der ersten Reliefstruktur 25 und der zweiten Reliefstruktur 26 abgeschieden wird, so daß im Ergebnis dieses Verfahrensschrittes die Flächendichte der Beschichtungen 231, 23n auf der ersten Reliefstruktur 25 und der zweiten Reliefstruktur 26 gleich und konstant ist. Auf diese Weise sind also keinerlei Vorkehrungen notwendig, um beispielsweise die Leitfähigkeit von Beschichtungen 23l, 23n unterschiedlich auszubilden und/oder um die Geometrie der Beschichtungen 23l, 23n zu erzeugen. Dabei ist es besonders vorteilhaft, daß die Strukturierung der Beschichtungen 231, 23n passergenau in einem Herstellungssschritt ausführbar ist und daß wegen der Mikrostrukturierung der Reliefstrukturen besonders hohe Auflösungen erzielt werden, wie sie beispielsweise zur Herstellung von Schaltkreisen nötig sind.

Anschließend wird die Klebeschicht 24 auf die Beschichtungen 23l, 23n aufgebracht. Bei der Klebeschicht 24 handelt es sich vorzugsweise um eine Schicht aus einem thermisch aktivierbaren Kleber. Je nach Einsatz des Sicherheitselements 11 ist es aber auch möglich, auf die Klebeschicht 24 zu verzichten.

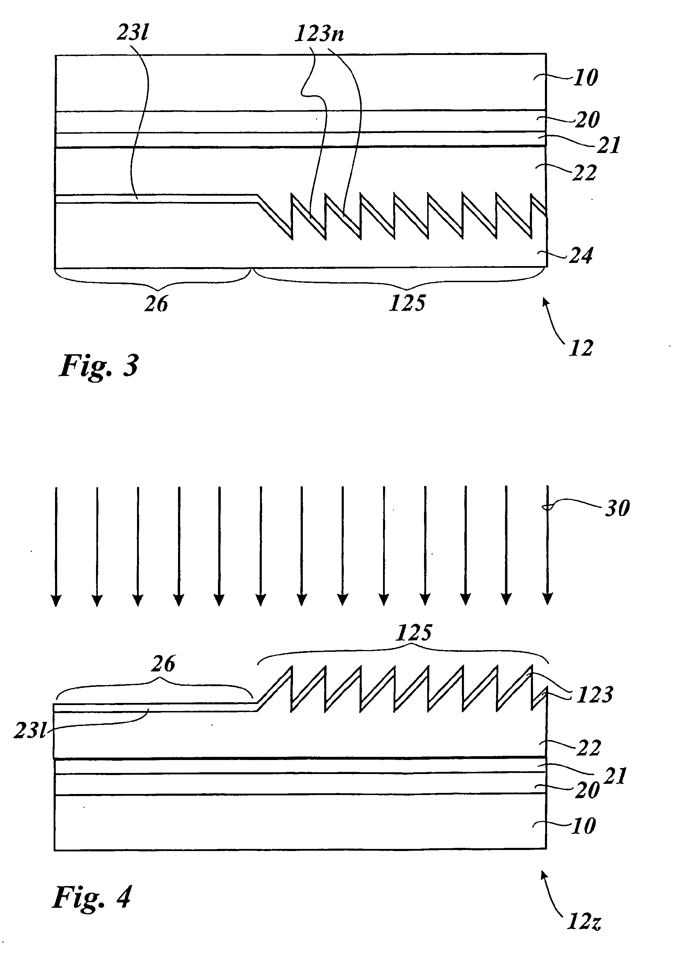

Fig. 3 zeigt nun ein zweites Ausführungsbeispiel eines mehrschichtigen Körpers in Form eines Folienelements 12 mit eindimensionaler erster Reliefstruktur, das sich nur in der Gestaltung der ersten Reliefstruktur von dem vorbeschriebenen Ausführungsbeispiel unterscheidet. Gleiche Elemente sind deshalb mit gleichen Bezugszeichen bezeichnet. Das Folienelement 12 ist anstelle der mäanderförmigen ersten Reliefstruktur 25 in Fig. 1 mit einer sägezahnförmigen ersten Reliefstruktur 125 ausgebildet. Die erste Reliefstruktur 125 weist eine zur Oberfläche der planaren zweiten Reliefstruktur 26 senkrecht angeordnete erste Flanke und eine zur ersten Flanke winkelig angeordnete zweite Flanke auf. Auf diese Weise ist erreicht, daß nur auf den zweiten Flanken der ersten Reliefstruktur 125 die Beschichtung 23n angeordnet ist, d.h. die Beschichtung unterbrochen ausgebildet ist.

Fig. 4 zeigt nun die Beschichtung der ersten Reliefstruktur 125 und der zweiten Reliefstruktur 26 in Fig. 3 mit Beschichtungen 123n und 231. Wie bereits vorstehend in Verbindung mit Fig. 2 beschrieben, werden die Beschichtungen 123n und 23l in einem gemeinsamen Herstellungssschritt, beispielsweise durch Sputtern, auf die erste Reliefstruktur 125 bzw. die zweite Reliefstruktur 26 aufgebracht. Wie in Fig. 4 gut zu erkennen ist, wird dabei auf den geneigten zweiten Flanken der ersten Reliefstruktur 125 die Beschichtung 123n mit geringerer Dicke ausgebildet als auf der senkrecht zur Aufbringungsrichtung angeordneten zweiten Reliefstruktur 26. Weil die Beschichtung 123n durch die nicht mit Material beschichteten senkrechten ersten Flanken der ersten Reliefstruktur 125 unterbrochen ist, ist beispielsweise eine so aufgebrachte Metallschicht elektrisch nichtleitend ausgebildet.

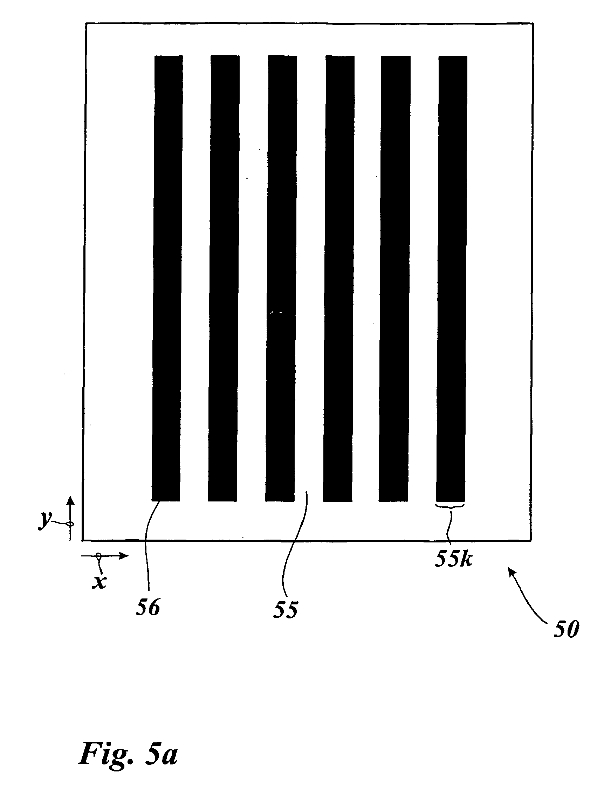

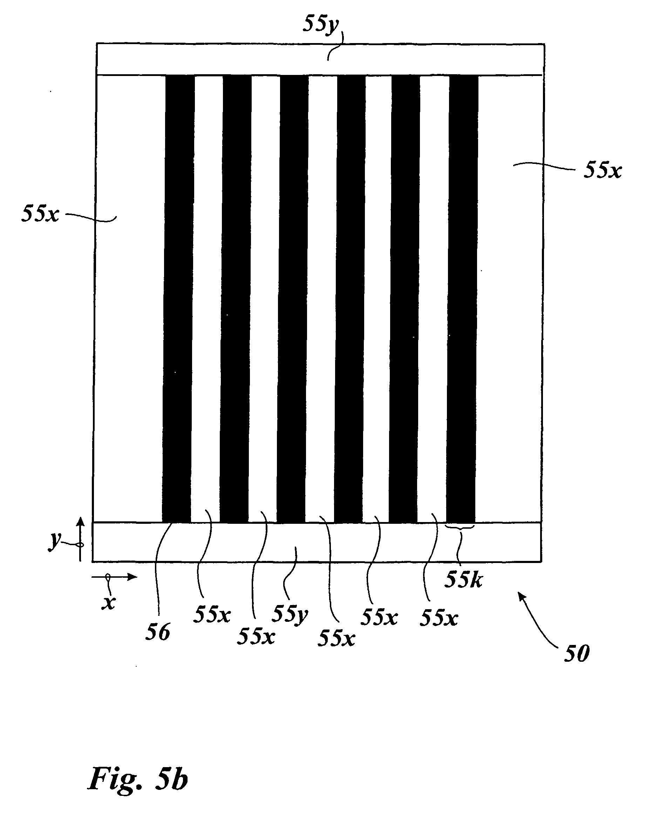

Fig. 5a zeigt nun in schematischer Darstellung eine Draufsicht auf einen mehrschichtigen Körper, ausgebildet als ein Folienelement 50 mit eindimensionaler erster Reliefstruktur, das im dargestellten Ausführungsbeispiel mit Metall beschichtet ist. Dabei ist ein elektrisch nichtleitender erster Bereich 55 mit eindimensionaler erster Reliefstruktur mit hohem Tiefen-zu-Breiten-Verhältnis von >2 ausgebildet, wie in Fig. 1 und 3 dargestellt (Pos. 25 bzw. 125), in den in Fig. 5 schwarz dargestellte leitende zweite Bereiche 56 mit planarer zweiter Reliefstruktur eingeschlossen sind. Es handelt sich dabei um Leiterbahnen, die nicht dargestellte elektrische Bauelemente miteinander verbinden.

Wenngleich der elektrisch nichtleitende erste Bereich 55 nur in der mit x bezeichneten Koordinatenrichtung durch unbeschichtete senkrechte Flanken unterbrochen ist und in Abschnitten 55k, in denen er in y-Richtung an elektrisch leitende zweite Bereiche 56 grenzt, lokal elektrisch kurzgeschlossen ist, hat er insgesamt eine elektrische Leitfähigkeit, die um Größenordnungen geringer ist, als die elektrische Leitfähigkeit der zweiten Bereiche 56.

In Fig. 5b ist nun dargestellt, wie der vorstehend beschriebene lokale Kurzschluß durch die leitenden zweiten Bereiche 56 vermieden werden kann. Dazu ist der erste Bereich 55 in Bereiche 55x und Bereiche 55y unterteilt, deren erste Reliefstrukturen in x-Richtung bzw. in y-Richtung variieren. Eine solche Anordnung kann vorgesehen sein, wenn die leitenden zweiten Bereiche 56 nicht zueinander parallel angeordnet sind bzw. kurvenförmig ausgebildet sind.

Es kann aber auch vorgesehen sein, die mit dem erfindungsgemäßen Verfahren aufgebrachten zweiten Bereiche 56 galvanisch zu verstärken. Weil die ersten Bereiche 55, 55x und 55y elektrisch nichtleitend ausgebildet sind, wird dort beim Galvanisieren kein Metall abgeschieden. Es sind also keine zusätzlichen Vorkehrungen zu treffen, um nur die leitenden zweiten Bereiche 56 galvanisch zu verstärken. Auf diese Weise sind die leitenden planaren zweiten Bereiche 56 als Leiterbahnen mit einem geringeren spezifischen Widerstand ausgebildet als vor der Galvanisierung. Es kann deshalb vorgesehen sein, auf die Ausbildung des ersten Bereichs 55 (s. Fig. 5a) in unterschiedlich orientierte Bereiche 55x und 55y (s. Fig. 5b) zu verzichten, weil die elektrische Leitfähigkeit der zweiten Bereiche 56 gegenüber der elektrischen Leitfähigkeit des ersten Bereiches 55 signifikant größer ist.

Die in den Fig. 5a und 5b dargestellten zweiten Bereiche 56 können transparent ausgebildet sein, beispielsweise wenn dort eine sehr dünne Metallschicht in der Größenordnung von 10nm aufgebracht ist, je nach Metallart differierend.

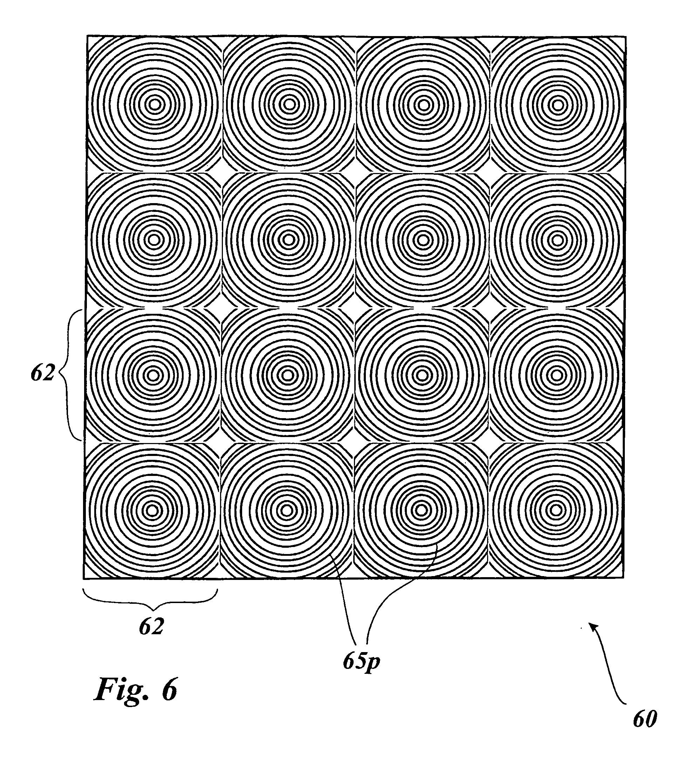

Fig. 6 zeigt nun in schematischer Darstellung eine Draufsicht auf einen mehrschichtigen Körper, ausgebildet als ein Folienelement 60 mit Rasterelementen 62, die in einem ersten Bereich erste Reliefstrukturen 65 aufweisen mit hohem Tiefen-zu-Breiten-Verhältnis von >2 und senkrechten Flanken, die in sich geschlossene Profilkurven 65p bilden. Im dargestellten Ausführungsbeispiel sind die Profilkurven als Kreise und Rhomben ausgebildet. Das Folienelement 60 ist mit einer nicht dargestellten Metallschicht beschichtet, die wegen der ersten Reliefstrukturen 65 im ersten Bereich nichtleitend ausgebildet ist. Es handelt sich hierbei um eine zweidimensionale Reliefstruktur, die den vorstehend genannten Nachteil eines möglichen Kurzschlusses durch elektrisch leitende Bereiche vermeidet. Wie in Fig. 6 gut zu sehen, sind die ersten Reliefstrukturen 65 aus konzentrisch angeordneten Kreisen gebildet, die in die quadratischen Rasterelemente 62 einbeschrieben sind. Auf diese Weise sind in den Eckbereichen der Rasterelemente 62 Kreissegmente ausgebildet. Auf diese Weise bilden die Kreissegmente eines Eckbereichs mit den Kreissegmenten der in diesem Eckbereich benachbarten drei weiteren Rasterelementen 62 rhombische Profilkurven aus, die zweite Bereiche umgeben.

Es kann vorgesehen sein, die Rasterelemente 62 mit gleicher Gestalt und mit gleicher Größe auszubilden, d.h. als gleichschenklige Dreiecke, Quadrate oder Sechsecke. Es kann auch vorgesehen sein, die Rasterelemente 62 ungleichförmig auszubilden, d.h. die Fläche des Folienelements 60 mit Rasterelementen 62 unterschiedlicher Gestalt und Größe auszufüllen. Es kommt nur darauf an, daß die senkrechten Flanken der ersten Reliefstruktur 65 geschlossene Kurven bilden.

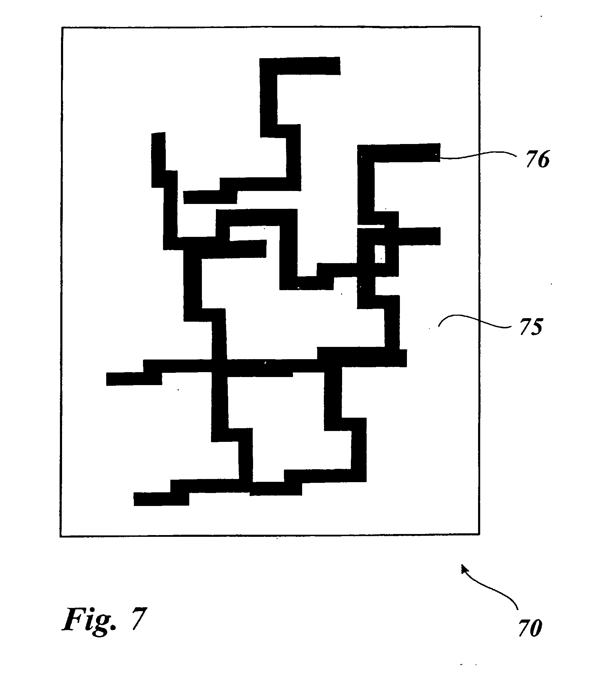

In Fig. 7 ist nun ein mit Metall beschichteter mehrschichtiger Körper, ausgebildet als Folienelement 70 mit einem strukturierten Leiter 76 in einem zweiten Bereich dargestellt, der von ersten Bereichen 75 umgeben ist, die mit ersten Reliefstrukturen mit hohem Tiefenzu-Breiten-Verhältnis von >2 ausgebildet sind.

Die ersten Reliefstrukturen können als eindimensionale Reliefstrukturen (s. Fig. 5) oder als zweidimensionale Reliefstrukturen (s. Fig. 6) mit hohem Tiefenzu-Breitenverhältnis von >2 ausgebildet sein. Bevorzugt ist eine zweidimensionale Reliefstruktur mit dem Tiefenzu-Breiten-Verhältnis > 2.

Das Folienelement 70 kann als Teil eines mikroelektronischen Schaltkreises ausgebildet sein, beispielsweise als Teil eines als Foliensystem ausgebildeten polymeren Schaltkreises. Dabei kann der Schaltkreis transparent ausgebildet sein, wie vorstehend beschrieben (s. Fig. 5).

Es kann bei einer solchen Anwendung vorgesehen sein, daß ein oder mehrere Abschnitte des strukturierten Leiters 76 mit einer Reliefstruktur mit einem Tiefen-zu-Breiten-Verhältnis ausgebildet sind, so daß die elektrische Leitfähigkeit des Leiters 76 in einem solchen Abschnitt vermindert ist. Auf diese Weise können beispielsweise elektrische Widerstände im Leiter 76 ausgebildet sein.

**Patentansprüche**

1. Mehrschichtiger Körper (11, 12) mit einer Replizierlackschicht (22), wobei in einer von Koordinatenachsen x und y aufgespannten Ebene in die Replizierlackschicht (22) eine erste Reliefstruktur (25, 125, 65) in einem ersten Bereich des mehrschichtigen Körpers abgeformt ist und auf die Replizierlackschicht (22) in dem ersten Bereich des mehrschichtigen Körpers (11, 12) und in einem benachbarten zweiten Bereich des mehrschichtigen Körpers (11, 12) eine elektrisch leitfähige Beschichtung (23l, 23n, 123n) mit konstanter Flächendichte aufgebracht ist, **dadurch gekennzeichnet,** **daß** die erste Reliefstruktur (25, 125, 65) eine Struktur mit einem hohen Tiefen-zu-Breiten-Verhältnis der einzelnen Strukturelemente von >2 ist, und mit mindestens einer sich über die gesamte oder nahezu gesamte Tiefe der Reliefstruktur erstreckenden senkrechten oder nahezu senkrechten Flanke ausgebildet ist, wobei sich an der Flanke der ersten Reliefstruktur (25, 125, 65) Bereiche ergeben, an denen die auf die erste Reliefstruktur aufgebrachte leitfähige Beschichtung (23l, 23n, 123n) nicht angelagert ist oder nur in einer derart geringen Schichtdicke angelagert ist, daß die elektrische Leitfähigkeit der Beschichtung (231, 23n, 123n) im Bereich der Flanke signifikant verringert ist.

2. Mehrschichtiger Körper nach Anspruch 1, **dadurch gekennzeichnet,** **daß** die Beschichtung eine Metallschicht ist.

3. Mehrschichtiger Körper nach Anspruch 1, **dadurch gekennzeichnet,** **daß** die Beschichtung aus einem transparenten leitfähigen Material, insbesondere Indium-Zinnoxid-Schicht (ITO) besteht.

4. Mehrschichtiger Körper nach einem der vorhergehenden Ansprüche, **dadurch gekennzeichnet,** **daß** die erste Reliefstruktur (25, 125, 65) als eine Funktion der Koordinaten x und/oder y ausgebildet ist, die die Tiefe der ersten Reliefstruktur (25, 125, 65) in x-Richtung und/oder in y-Richtung periodisch variiert.

5. Mehrschichtiger Körper nach Anspruch 4, **dadurch gekennzeichnet,** **daß** die erste Reliefstruktur (25) im wesentlichen als eine Rechteckfunktion der Koordinaten x oder y ausgebildet ist, die die Tiefe der ersten Reliefstruktur (25) in x-Richtung oder in y-Richtung periodisch variiert.

6. Mehrschichtiger Körper nach Anspruch 4, **dadurch gekennzeichnet,** **daß** die erste Reliefstruktur (125) als eine Sägezahnfunktion der Koordinaten x oder y ausgebildet ist, die die Tiefe der ersten Reliefstruktur (125) in x- Richtung oder in y-Richtung periodisch variiert.

7. Mehrschichtiger Körper nach Anspruch 4,

**dadurch gekennzeichnet,**
**daß** die erste Reliefstruktur (65) als eine Rechteckfunktion oder eine Sägezahnfunktion der Koordinaten x und y ausgebildet ist, die die Tiefe der ersten Reliefstruktur (125) in x-Richtung und in y-Richtung periodisch variiert, wobei die senkrechten Flanken dieser Funktionen in sich geschlossene konvexe Kurven bilden.

8. Mehrschichtiger Körper nach einem der vorhergehenden Ansprüche,
**dadurch gekennzeichnet,**
**daß** in dem benachbarten zweiten Bereich in die Replizierlackschicht (22) eine zweite Reliefstruktur (26) abgeformt ist.

9. Mehrschichtiger Körper nach Anspruch 8,
**dadurch gekennzeichnet,**
**daß** die zweite Reliefstruktur (26) im wesentlichen planar oder mit einem niedrigeren Tiefen-zu-Breiten-Verhältnis ausgebildet ist als die erste Reliefstruktur (25, 125, 65).

10. Mehrschichtiger Körper nach Anspruch 8,
**dadurch gekennzeichnet,**
**daß** die zweite Reliefstruktur (26) als eine Funktion der Koordinaten x und/oder y ausgebildet ist, die die Tiefe der Reliefstruktur (26) in x-Richtung und/oder in y-Richtung variiert, wobei diese Funktion ohne senkrechte Flanke ausgebildet ist.

11. Mehrschichtiger Körper nach einem der vorhergehenden Ansprüche,
**dadurch gekennzeichnet,**
**daß** die auf der zweiten Reliefstruktur (26) aufgebrachte Beschichtung (23l) transparent ausgebildet ist.

12. Mehrschichtiger Körper nach Anspruch 11,
**dadurch gekennzeichnet,**
**daß** die transparente Beschichtung als eine Metallschicht mit einer Dicke von 1 nm bis 100 nm ausgebildet ist, vorzugsweise mit einer Dicke von 5 nm bis 30 nm.

13. Mehrschichtiger Körper nach einem der vorhergehenden Ansprüche,
**dadurch gekennzeichnet,**
**daß** der mehrschichtige Folienkörper eine Transferfolie, insbesondere eine Heißprägefolie, ist.

14. Schaltkreis, insbesondere aus Polymerstrukturen gebildeter Schaltkreis, mit einem mehrschichtigen Körper nach einem der vorhergehenden Ansprüche.

15. Linearpolarisator mit einem mehrschichtigen Körper nach einem der Ansprüche 1 bis 13.

16. Sicherheitselement mit als Linearpolarisator nach Anspruch 15 ausgebildeten Bereichen, wobei die Bereiche als Informationsträger ausgebildet sind, beispielsweise als Strichcode, alphanumerisches Zeichen oder Bilddarstellung.

17. Sicherheitsdokument, insbesondere Banknote, Reisepaß oder Warenetikett mit einem mehrschichtigen Körper nach einem der vorhergehenden Ansprüche.

18. Verfahren zur Herstellung eines mehrschichtigen Körpers (11, 12), wobei bei dem Verfahren in eine Replizierlackschicht (22) des mehrschichtigen Körpers in einem ersten Bereich des mehrschichtigen Körpers (11, 12) eine erste Reliefstruktur (25, 125) abgeformt wird und auf die Replizierlackschicht (22) in dem ersten Bereich des mehrschichtigen Körpers (11, 12) und in einem benachbarten zweiten Bereich des mehrschichtigen Körpers (11, 12) eine elektrisch leitfähige Beschichtung (23l, 23n, 123n) mit konstanter Flächendichte aufgebracht wird,
**dadurch gekennzeichnet,**
**daß** die erste Reliefstruktur (25, 125) als eine Struktur mit einem hohen Tiefen-zu-Breiten-Verhältnis der einzelnen Strukturelemente von > 2, und mindestens einer senkrechten oder nahezu senkrechten Flanke abgeformt wird, wobei sich an der Flanke der ersten Reliefstruktur (25, 125) Bereiche ergeben, an denen die auf die erste Reliefstruktur aufgebrachte leitfähige Beschichtung (23l, 23n, 123n) nicht angelagert ist oder nur in einer derart geringen Schichtdicke angelagert ist, daß die elektrische Leitfähigkeit der Beschichtung (23l, 23n, 123n) im Bereich der Flanke signifikant verringert ist.

19. Verfahren nach Anspruch 18,
**dadurch gekennzeichnet,**
**daß** die Beschichtung (231, 23n, 123n) durch Sputtern auf die Replizierlackschicht (22) aufgebracht wird.

20. Verfahren nach Anspruch 19,
**dadurch gekennzeichnet,**
**daß** die Beschichtung (23l, 23n, 123n) durch Elektronenstrahlbedampfen auf die Replizierlackschicht (22) aufgebracht wird.

21. Verfahren nach Anspruch 20,
**dadurch gekennzeichnet,**
**daß** die Beschichtung (23l, 23n, 123n) durch thermisches Bedampfen mit Widerstandsheizung auf die Replizierlackschicht (22) aufgebracht wird.

22. Verfahren nach einem der Ansprüche 18 bis 21,
**dadurch gekennzeichnet,**
**daß** die Beschichtung (23l, 23n, 123n) galvanisch verstärkt wird.

**23.** Verfahren nach Anspruch 18,
**dadurch gekennzeichnet,**
**daß** die Reliefstrukturen mittels UV-Replikation in der Replizierlackschicht (22) abgeformt werden.

## Claims

**1.** Multilayer body (11, 12) having a replication lacquer layer (22), a first relief structure (25, 125, 65) in a first area of the multilayer body being impressed into the replication lacquer layer (22) in a plane defined by coordinate axes x and y, and an electrically conductive coating (231, 23n, 123n) of constant surface density being applied to the replication lacquer layer (22) in the first area of the multilayer body (11, 12) and in an adjacent second area of the multilayer body (11, 12), **characterized in that** the first relief structure (25, 125, 65) is a structure with a high depth-to-width ratio of the individual structural elements of >2 and is constructed with at least one vertical or virtually vertical flank extending over the entire or virtually entire depth of the relief structure, there arising at the flank of the first relief structure (25, 125, 65) areas on which the conductive coating (231, 23n, 123n) applied to the first relief structure has not accumulated, or has accumulated only in a layer thickness so slight that the electrical conductivity of the coating (231, 23n, 123n) in the area of the flank is significantly reduced.

**2.** Multilayer body according to Claim 1, **characterized in that** the coating is a metal layer.

**3.** Multilayer body according to Claim 1, **characterized in that** the coating consists of a transparent conductive material, in particular an indium tin oxide (ITO) layer.

**4.** Multilayer body according to one of the preceding claims, **characterized in that** the first relief structure (25, 125, 65) is constructed as a function of the coordinates x and/or y which periodically varies the depth of the first relief structure (25, 125, 65) in the x-direction and/or in the y-direction.

**5.** Multilayer body according to Claim 4, **characterized in that** the first relief structure (25) is substantially constructed as a rectangular function of the coordinates x or y which periodically varies the depth of the first relief structure (25) in the x-direction or in the y-direction.

**6.** Multilayer body according to Claim 4, **characterized in that** the first relief structure (125) is constructed as a sawtooth function of the coordinates x or y which periodically varies the depth of the first relief structure (125) in the x-direction or in the y-direction.

**7.** Multilayer body according to Claim 4, **characterized in that** the first relief structure (65) is constructed as a rectangular function or a sawtooth function of the coordinates x and y which periodically varies the depth of the first relief structure (125) in the x-direction and in the y-direction, the vertical flanks of these functions forming closed convex curves.

**8.** Multilayer body according to one of the preceding claims, **characterized in that** a second relief structure (26) is impressed into the replication lacquer layer (22) in the adjacent second area.

**9.** Multilayer body according to Claim 8, **characterized in that** the second relief structure (26) is constructed in a substantially planar fashion or with a lower depth-to-width ratio than the first relief structure (25, 125, 65).

**10.** Multilayer body according to Claim 8, **characterized in that** the second relief structure (26) is constructed as a function of the coordinates x and/or y which varies the depth of the relief structure (26) in the x-direction and/or in the y-direction, this function being constructed without a vertical flank.

**11.** Multilayer body according to one of the preceding claims, **characterized in that** the coating (231) applied to the second relief structure (26) is of transparent construction.

**12.** Multilayer body according to Claim 11, **characterized in that** the transparent coating is constructed as a metal layer with a thickness of 1 nm to 100 nm, preferably with a thickness of 5 nm to 30 nm.

**13.** Multilayer body according to one of the preceding claims, **characterized in that** the multilayer film body is a transfer film, in particular a hot embossing film.

**14.** Circuit, in particular a circuit formed from polymer structures, having a multilayer body according to one of the preceding claims.

**15.** Linear polariser having a multilayer body according to one of Claims 1 to 13.

**16.** Security element having areas constructed as linear polariser according to Claim 15, in which the areas are constructed as an information carrier, for example, a bar code, alphanumeric character or a graphic representation.

**17.** Security document, in particular banknote, passport or a goods label having a multilayer body according to one of the preceding claims.

**18.** Method for producing a multilayer body (11, 12), during the method a first relief structure (25, 125) being impressed in a first area of the multilayer body (11, 12) into a replication lacquer layer (22) of the multilayer body, and an electrically conductive coating (231, 23n, 123n) of constant surface density being applied to the replication lacquer layer (22) in the first area of the multilayer body (11, 12) and in an adjacent second area of the multilayer body (11, 12), **characterized in that** the first relief structure (25, 125) is impressed as a structure with a high depth-to-width ratio of the individual structural elements of > 2 and at least one vertical or virtually vertical flank, there arising at the flank of the first relief structure (25, 125) areas on which the conductive coating (231, 23n, 123n) applied to the first relief structure has not accumulated, or has accumulated only in a layer thickness so slight that the electrical conductivity of the coating (231, 23n, 123n) in the area of the flank is significantly reduced.

**19.** Method according to Claim 18, **characterized in that** the coating (231, 23n, 123n) is applied to the replication lacquer layer (22) by sputtering.

**20.** Method according to Claim 19, **characterized in that** the coating (231, 23n, 123n) is applied to the replication lacquer layer (22) by electron beam deposition.

**21.** Method according to Claim 20, **characterized in that** the coating (231, 23n, 123n) is applied to the replication lacquer layer (22) by thermal deposition with resistance heating.

**22.** Method according to one of Claims 18 to 21, **characterized in that** the coating (231, 23n, 123n) is galvanically reinforced.

**23.** Method according to Claim 18, **characterized in that** the relief structures are impressed by means of UV replication in the replication lacquer layer (22).

**Revendications**

**1.** Corps multicouche (11, 12) avec une couche de laque de réplique (22), dans lequel dans un plan défini par des axes de coordonnée x et y dans la couche de laque de réplique (22) est moulée une première structure en relief (25, 125, 65) dans une première zone du corps multicouche et sur la couche de laque de réplique (22) dans la première zone du corps (11, 12) multicouche et dans une seconde zone contigüe du corps multicouche (11, 12) est appliqué un revêtement (231, 23n, 123n) électroconducteur avec une densité superficielle constante, **caractérisé en ce que**

la première structure en relief (25, 125, 65) est une structure avec un rapport élevé profondeur-largeur de chaque élément structurel > 2, et est réalisée avec au moins un flanc perpendiculaire ou presque perpendiculaire s'étendant sur toute la profondeur ou presque toute la profondeur de la structure en relief, dans lequel des zones résultent sur le flanc de la première structure en relief (25, 125, 65), sur lesquelles le revêtement (231, 23n, 123n) conducteur appliqué sur la première structure en relief n'est pas fixé ou est fixé seulement dans une épaisseur de couche faible de sorte que la conductibilité électrique du revêtement (231, 23n, 123n) soit réduite de manière significative dans la zone du flanc.

**2.** Corps multicouche selon la revendication 1, **caractérisé en ce que** le revêtement est une couche métallique.

**3.** Corps multicouche selon la revendication 1, **caractérisé en ce que** le revêtement se compose d'un matériau conducteur transparent, en particulier d'une couche d'indium et d'oxyde d'étain (ITO).

**4.** Corps multicouche selon l'une quelconque des revendications précédentes, **caractérisé en ce que** la première structure en relief (25, 125, 65) est réalisée comme une fonction des coordonnées x et/ou y qui varie périodiquement la profondeur de la première structure en relief (25, 125, 65) dans le sens x et/ou dans le sens y.

**5.** Corps multicouche selon la revendication 4, **caractérisé en ce que** la première structure en relief (25) est réalisée essentiellement comme une fonction rectangulaire des coordonnées x ou y qui varie périodiquement la profondeur de la première structure en relief (125) dans le sens x et/ou dans le sens y.

**6.** Corps multicouche selon la revendication 4, **caractérisé en ce que** la première structure en relief (125) est réalisée comme une fonction en dent de scie des coordonnées x ou y qui varie périodiquement la profondeur de la première structure en relief (125) dans le sens x et/ou dans le sens y.

**7.** Corps multicouche selon la revendication 4, **caractérisé en ce que** la première structure en relief (65) est réalisée comme une fonction rectangulaire ou une fonction en dent de scie des coordonnées x et y qui varie périodiquement la profondeur de la première structure en relief (125) dans le sens x et dans le sens y, les flancs perpendiculaires de ces fonctions formant des courbes convexes fermées en soi.

**8.** Corps multicouche selon l'une quelconque des revendications précédentes,
**caractérisé en ce que**
une seconde structure en relief (26) est moulée dans la seconde zone contiguë dans la couche de laque de réplique (22).

**9.** Corps multicouche selon la revendication 8,
**caractérisé en ce que**
la seconde structure en relief (26) est réalisée essentiellement plane ou avec un rapport plus faible profondeur-largeur que la première structure en relief (25, 125, 65).

**10.** Corps multicouche selon la revendication 8,
**caractérisé en ce que**
la seconde structure en relief (26) est réalisée comme une fonction des coordonnées x et/ou y qui varie périodiquement la profondeur de la structure en relief (26) dans le sens x et/ou dans le sens y, cette fonction étant réalisée sans flanc perpendiculaire.

**11.** Corps multicouche selon l'une quelconque des revendications précédentes,
**caractérisé en ce que**
le revêtement (231) appliqué sur la seconde structure en relief (26) est réalisé transparent.

**12.** Corps multicouche selon la revendication 11,
**caractérisé en ce que**
le revêtement transparent est réalisé comme une couche métallique avec une épaisseur de 1 nm à 100 nm, de préférence avec une épaisseur de 5 nm à 30 nm.

**13.** Corps multicouche selon l'une quelconque des revendications précédentes,
**caractérisé en ce que**
le corps de film multicouche est un film de transfert, en particulier un film d'estampage à chaud.

**14.** Circuit, en particulier circuit formé de structures en polymère avec un corps multicouche selon l'une quelconque des revendications précédentes.

**15.** Polariseur linéaire avec un corps multicouche selon l'une quelconque des revendications 1 à 13.

**16.** Elément de sécurité avec des zones réalisées comme polariseur linéaire selon la revendication 15, dans lequel les zones sont réalisées comme support d'informations, par exemple comme un code barre, un caractère alphanumérique ou une présentation.

**17.** Document de sécurité, en particulier billet de banque, passeport ou étiquette de marchandises avec un corps multicouche selon l'une quelconque des revendications précédentes.

**18.** Procédé de production d'un corps (11, 12) multicouche, dans lequel pour le procédé, une première structure en relief (25, 125) est moulée dans une couche de laque de réplique (22) du corps multicouche dans une première zone du corps (11, 12) multicouche et un revêtement (231, 23n, 123n) électroconducteur avec une densité superficielle constante est appliqué sur la couche de laque de réplique (22) dans la première zone du corps (11, 12) multicouche et dans une seconde zone contigüe du corps (11, 12) multicouche,
**caractérisé en ce que**
la première structure en relief (25, 125) est une structure avec un rapport élevé profondeur-largeur de chaque élément structurel > 2, et est moulée dans au moins un flanc perpendiculaire ou presque perpendiculaire, dans lequel des zones résultent sur le flanc de la première structure en relief (25, 125), sur lesquelles le revêtement (23l, 23n, 123n) conducteur appliqué sur la première structure en relief n'est pas fixé ou est fixé seulement dans une épaisseur de couche faible de sorte que la conductibilité électrique du revêtement (23l, 23n, 123n) soit réduite de manière significative dans la zone du flanc.

**19.** Procédé selon la revendication 18,
**caractérisé en ce que**
le revêtement (23l, 23n, 123n) est appliqué par pulvérisation cathodique sur la couche de laque de réplique (22).

**20.** Procédé selon la revendication 19,
**caractérisé en ce que**
le revêtement (23l, 23n, 123n) est appliqué par métallisation à faisceau électronique sur la couche de laque de réplique (22).

**21.** Procédé selon la revendication 20,
**caractérisé en ce que** le revêtement (231, 23n, 123n) est appliqué par métallisation thermique avec chauffage ohmique sur la couche de laque de réplique (22).

**22.** Procédé selon l'une quelconque des revendications 18 à 21,
**caractérisé en ce que**
le revêtement (23l, 23n, 123n) est renforcé galvaniquement.

**23.** Procédé selon la revendication 18,
**caractérisé en ce que**
les structures en relief sont moulées au moyen de la réplique par ultraviolets dans la couche de laque de réplique (22).

*Fig. 1*

*Fig. 2*

**Fig. 3**

**Fig. 4**

*Fig. 5a*

**Fig. 5b**

62

62

65p

Fig. 6

60

*Fig. 7*

76

75

70

**EP 1 785 016 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6284072 B1